# EUROPEAN PATENT APPLICATION

(11) **EP 2 698 918 A1**
(43) Date of publication of application: **19.02.2014**
(21) Application number: 12180465.2
(22) Date of filing: 14.08.2012
(51) Int. Cl.: H03F 1/02

(54) **Amplifier circuit**

(71) Applicant: NXP B.V., 5656 AG Eindhoven (NL)
(72) Inventor: Van Rijs, Fred, 5656 AG Eindhoven (NL); Qureshi, Jawad, 5656 AG Eindhoven (NL); Gajadharsing, John, 5656 AG Eindhoven (NL); Neo, Edmund, 5656 AG Eindhoven (NL); Zhao, Ji, 5656 AG Eindhoven (NL)
(74) Representative: Schouten, Marcus Maria

(57) **Abstract**

A Doherty power amplifier circuit is disclosed. The circuit comprises a main amplifier and peak amplifier connected to an output terminal of the circuit via a transmission line impedance invertor. The transmission line impedance invertor comprises: a first transmission line connected between the main amplifier and the output terminal; and a second transmission line connected between the peak amplifier and the output terminal.

## Description

This invention relates to an amplifier circuit, and more particularly to a Doherty power amplifier circuit.

Doherty Power Amplifier (DPA) circuits are widely used in Radio Frequency (RF) power transmitters. Doherty amplification is a well-known technique for improving the power efficiency of RF transmitters when dealing with modulated signals that have high peak-to-average ratios e.g. MC-GSM, WCDMA and OFDM (where power efficiency is defined as the ratio of average output power of the PA to the DC input power).

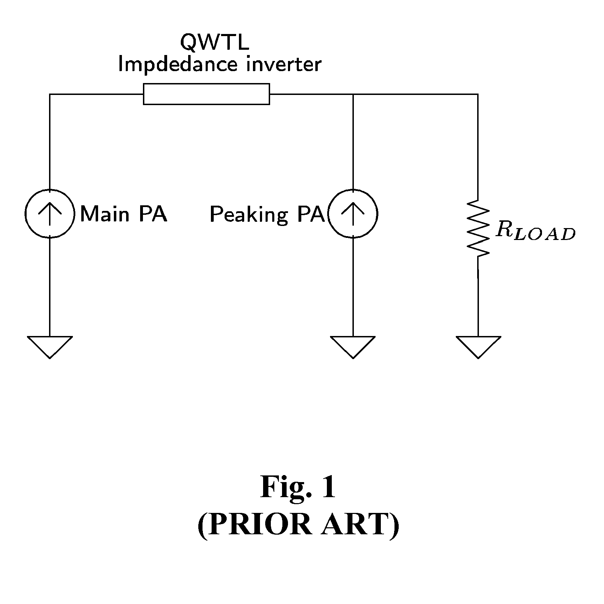

A schematic of a DPA in its most elementary form is shown in Figure 1 and details of its operation are well known in the field of amplifier circuits. Consequently, detailed explanation of the DPA of Figure 1 will be omitted.

The concept of Doherty amplification typically improves the average efficiency of a transmitter it is employed with and can provide average efficiencies of more than 50% for modern WCDMA and MC-GSM signals. It is therefore widely used in cellular and broadcast base-station transmitters.

However, the requirements of microwave transmitters are now shifting towards wider RF bandwidths along-with higher-average efficiencies. By way of example, transmitted signals for next generation base-station transmitters have bandwidths in excess of 100 MHz and, if the pre-distortion overhead on the bandwidth is included, the power amplifier for such signals need to handle signal bandwidths of more than 400MHz.

Further, there is also growing demand for multi-band high-average efficiency power amplifiers. For example, in broadcast applications a multi-band DPA may be required to operate over a wide bandwidth (from 460MHz to 860MHz, from example) with an average efficiency drop of no more than 10 percentage points and peak power drop of not more than 0.5dB in the band.

The fractional efficiency/power bandwidth of conventional high power DPAs is no more than 10 to 15%. This is clearly inadequate to meet the above-mentioned requirements.

It has been shown that the Doherty amplification concept, in its most basic form, can provide a fractional efficiency bandwidth of 28%. This bandwidth is calculated by assuming that at the efficiency at the band edges drop by 10 percentage points. Moreover, the above-mentioned bandwidth is calculated by assuming that the output capacitance of the DPA is equal to zero and there is no frequency dependent network between the power combiner and internal current source of the DPA device. However, real DPA devices have an output capacitance along with a package parasitic capacitance. These capacitances result in undesired frequency dependent impedance transformation and prevent the application of a power combiner directly at the internal current source.

In order to cancel the effects of these undesired parasitic components, it is known to provide an additional passive network between the impedance inverter and the PA device. Although this approach can work well at the design frequency, the frequency response of the networks severely limits the wideband performance of the DPA. Thus, the bandwidth of the resulting DPA is much more limited by the bandwidth of the transformation networks TN1 and TN2 rather than the impedance inverter itself. Therefore, the typical RF bandwidth obtained by conventional high power DPA lies in the range of 10 to 15%.

Proposed is a concept for enhancing the bandwidth of a DPA through the use of a novel wideband power combiner. The proposed power combiner is adapted to act like a very wideband PA combiner at back-off (i.e. reduced) power levels (in other words, when operating a power levels lower than those of a fully operating state) without compromising any bandwidth at full power levels. Such a proposed power combiner may be easily used with existing RF Power Amplifier (PA) devices.

According to an aspect of the invention there is provided a Doherty power amplifier circuit according to the independent claim.

Embodiments of the invention may increase the bandwidth of a high power DPA though the use of a transmission line impedance invertor or power combiner. The transmission line impedance invertor may be adapted to absorb device and package parasitic capacitances in its power combining network. Moreover, the proposed transmission line impedance invertor may widen the bandwidth of a DPA circuit without compromising its bandwidth under full-power levels.

Embodiments may provide an increase in bandwidth of 3 to 5 times that of a conventional DPA circuit.

Examples of the invention will now be described in detail with reference to the accompanying drawings, in which:
Figure 1 is a diagram of a conventional DPA circuit;
Figure 2 is a schematic diagram of a DPA circuit according to a first embodiment of the invention;
Figure 3a is a graph illustrating the variation of the magnitude of the input impedance with frequency (i.e. the frequency response) for the DPA circuits of Figures 1 and 2;
Figure 3b is a graph illustrating the variation of the phase of the input impedance with frequency (i.e. the phase response) for the amplifier circuits of Figures 1 and 2;
Figure 4 is a is a graph illustrating the variation of the efficiency with frequency for the amplifier circuits of Figures 1 and 2;
Figure 5 illustrates a modification to the embodiment of Figure 2;
Figure 6 is a graph illustrating the simulated efficiency bandwidth at a back-off power level for a conventional asymmetric DPA and an asymmetric DPA according to an embodiment of the invention;
Figure 7 is a schematic diagram of a DPA circuit according to an embodiment of the invention that is designed with packaged PA devices;
Figure 8 is a graph depicting the simulated variation of efficiency with output power at various frequencies for the DPA circuit of Figure 7;
Figure 9 is a schematic diagram of an integrated asymmetric DPA circuit according to an embodiment of the invention;
Figure 10 is an assembly diagram of the integrated DPA circuit of Figure 9;
Figure 11 shows a simplified schematic diagram of an integrated DPA circuit according to another embodiment;
Figure 12A is a schematic circuit diagram of the packaged main power amplifier of the embodiment shown in Figure 11; and
Figure 12B is a schematic circuit diagram of the packaged peaking power amplifier of the embodiment shown in Figure 11.

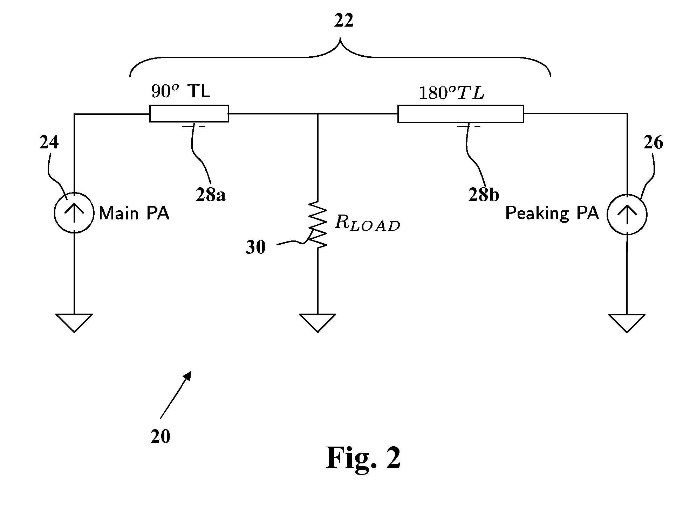

Referring to Figure 2, there is shown a basic schematic diagram of an amplifier circuit 20 according to an embodiment of the invention. Unlike the conventional circuit arrangement of Figure 1, circuit of Figure 2 comprises a transmission line (TL) impedance inverter 22 (between the main power amplifier 24, represented by a current source, and the peaking power amplifier 26, also represented by a current source) which contains first 28a and second 28b TLs. The first TL 28a is a 90° TL connected to the main power amplifier 24 at one end. In other words, the first TL 28a has an electrical length of π/2 (i.e. quarter wavelength) at the centre frequency of the design. The second TL 28b is a 180° TL connected to the peaking power amplifier 26 at one. In other words, the second TL 28b has an electrical length of π (i.e. half wavelength) at the centre frequency of the design. The other ends of the first 28a and second 28b transmission lines are connected to each other.

Also unlike the conventional circuit arrangement of Figure 1, the load resistance 30 (R_{LOAD}) is connected to ground between the first 28a and second 28b transmission lines (such that it is connected in parallel with the main power amplifier 24 and the peaking power amplifier 26).

The impedance inverter 22 is adapted to act as a wideband impedance inverter at a back-off (i.e. reduced) power level.

More specifically, when operating at a reduced power level, the peaking power amplifier 26 is in an OFF state and second TL 28b is in an open circuit configuration. The open circuited second TL 28b then acts as a compensation line for the first transmission line 28a of the impedance inverter 22, thus improving its frequency response.

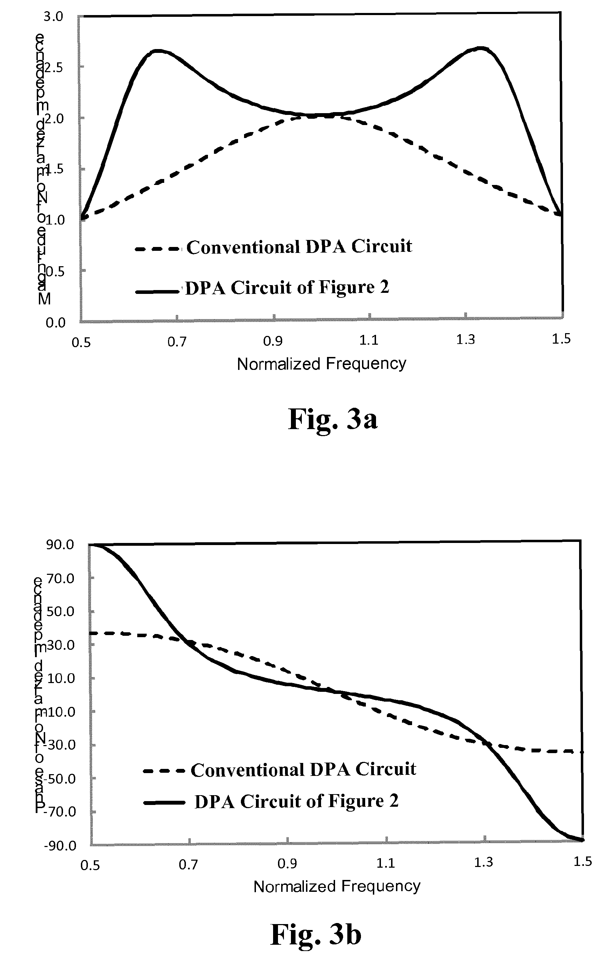

The frequency and phase response of this DPA circuit is shown in Figure 3a and 3b, respectively, along with frequency response of a conventional DPA circuit. Here, it is noted that impedances are normalized to the optimum impedance of the PA devices, and load impedance is assumed to be equal to 0.5 (i.e. a 2-Way symmetric DPA case).

It can be clearly seen that the impedance inverter of Figure 2 can maintain a high impedance level over much wider bandwidth than the conventional DPA circuit. Indeed, the usable frequency of the impedance inverter of Figure 2 may be in the range of 0.6 to 1.3 (normalized to designed frequency), thus leading to a fractional bandwidth of 70%. Beyond this frequency range, the impedance value drops much more rapidly and the magnitude of the phase of the input impedance is also increased.

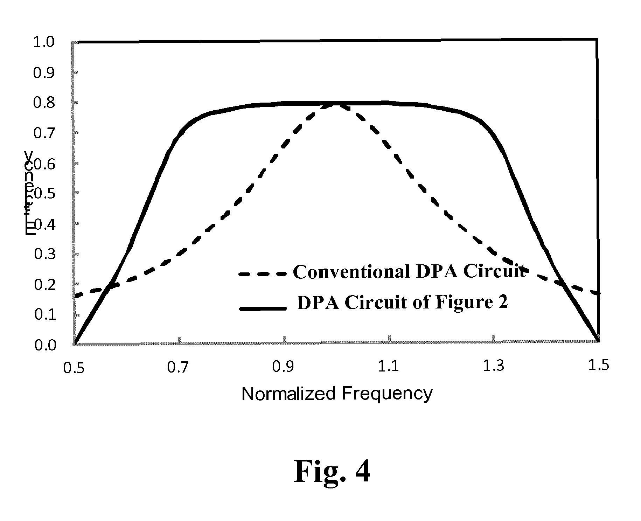

In order to estimate the efficiency bandwidth improvement over the conventional DPA circuit, the efficiency of a conventional arrangement of Figure 1 as well as the arrangement of Figure 2 is calculated using the variations of the magnitude and phase of the input impedance illustrated in Figures 3a and 3b. The results are plotted as a graph shown in Figure 4. The graph of Figure 4 shows that the proposed arrangement of Figure 2 can maintain high efficiency at back-off power levels for a much broader frequency range as compared to the conventional DPA circuit of Figure 1.

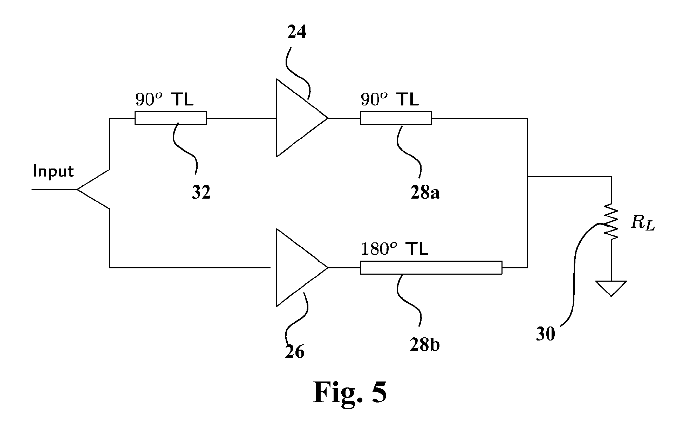

Figure 5 illustrates a modification to the embodiment of Figure 2 that may be employed to compensate for the additional phase shift caused by the second TL 28b (i.e. the 180° line). Specifically, in the embodiment of Figure 5, an additional 90° TL 32 is employed at the input before the main power amplifier 24. Thus, in principle, under full power conditions, the embodiment of Figure 5 will have no bandwidth restrictions.

It should be understood that embodiments are not limited to symmetric DPA designs only. If another peaking power amplifier is added with another 180° TL, or the size of the existing power amplifier device is increased, the proposed concept can be extended to an asymmetric DPA design.

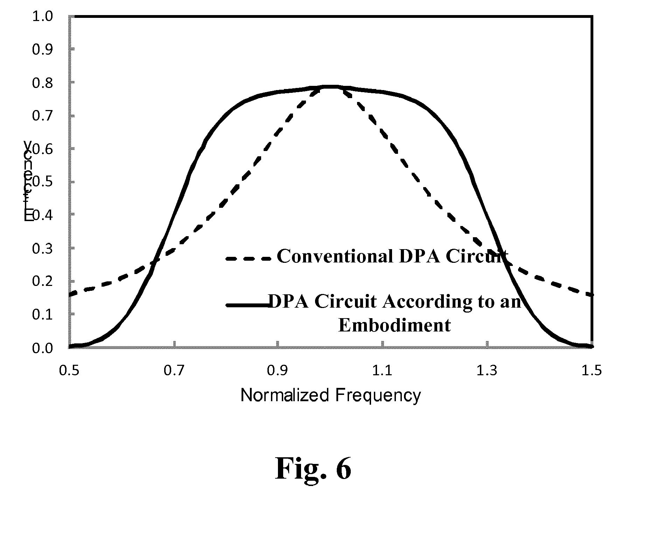

Simulation results for the efficiency bandwidth at a back-off power level for a conventional asymmetric DPA and an asymmetric DPA according to the invention are shown in the Figure 6. From this it can be appreciated that an asymmetric DPA according to the invention shows 2 to 3 times improvement in efficiency bandwidth compared to a conventional asymmetric DPA.

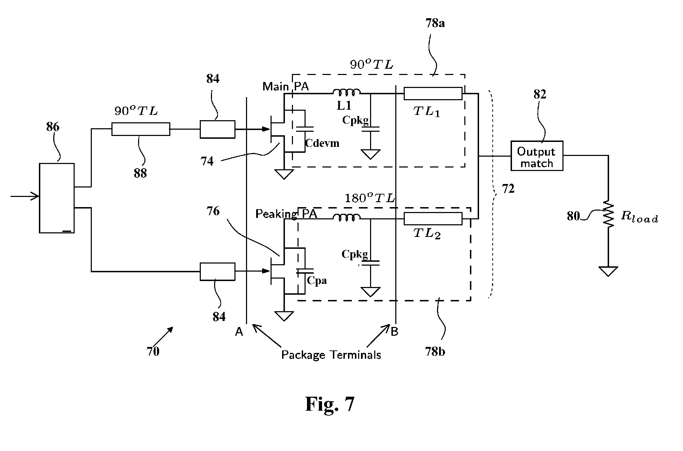

To demonstrate application of the invention to High Power Discrete PA devices, an embodiment of a symmetric DPA with High Power DPA devices will now be described with reference to Figure 7. Figure 7 is a schematic diagram of a DPA circuit according to an embodiment of the invention that is designed with packaged PA devices. Here the packaged PA devices are 24mm GaN devices in a SOT1135 package.

The DPA circuit 70 comprises a TL impedance inverter 72 connected between a main power amplifier 74 and a peaking power amplifier 76 (wherein the amplifiers 74 and 76 are housed in a package indicated by lines A and B).

The TL impedance inverter 72 is formed from first 78a and second 78b TLs in connected in series with each other. The first TL 78a is a 90° TL connected to the main power amplifier 74. The second TL 78b is a 180° TL connected to the peaking power amplifier 76.

The first (90°) TL 78a is formed from a first transmission line impedance TL1 along with the device output capacitance Cdevm, the package capacitance Cpkg, and the bondwire inductance L1.

The second (180°) TL 78b is formed from a second transmission line impedance TL2 along with the package capacitance Cpkg and parasitic capacitance Cpa of the peaking power amplifier 76.

It is noted that the characteristics of these quasi-lumped transmission lines 78a and 78b are arranged to be equal to the real optimum load of the DPA 80 for maximum power conditions. In this way, power combining is achieved without impedance transformation. The transformation from the optimum impedance of the device to the load 80 (here 50Ω) is done by a wideband matching network indicated by the block 82 in Figure 7.

It is also noted that, in the embodiment of Figure 7, the wideband input matching networks 84 are provide and these matching networks 84 and output matching network 82 are not included in the package and are provided with the components outside the package. Moreover, the DPA circuit of Figure 7 is also used with an external wideband input signal splitter/divider 86 which divided the input signal into a separate signal for each input of the DPA circuit. Also, a phase compensation network 88 (for example, a 90° transmission line) is employed at the input of the main power amplifier 74. This is to compensate for the additional phase shift caused by the 180° transmission lines connected to the peaking power amplifiers 104 and 106.

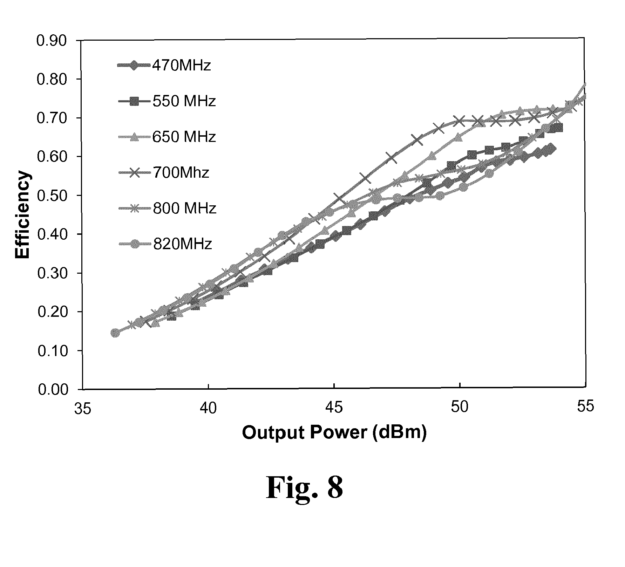

The DPA circuit 70 of Figure 7 has been simulated using previously developed GaN HEMT device models and a circuit simulator. The results of these simulation are illustrated in Figure 8, which is a graph depicting the variation of efficiency with output power at various frequencies.

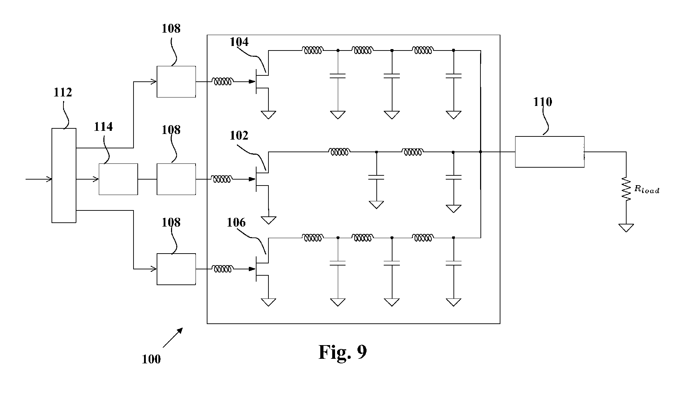

Embodiments of the invention may also provide for simplified design of an integrated DPA circuit. An integrated DPA according to the invention can be made with two conventional dice along-with a capacitor placed in the package. Note the wideband DPA combiner is made with the bond-wires, device output capacitance and an external capacitor placed in the package. The input of such a DPA circuit may be designed in the same way as a conventional discrete DPA using a wideband signal splitter at the input. A schematic diagram of such an integrated asymmetric DPA according to the invention is shown in Figure 9. Here, it is noted that the DPA circuit 100 contains one main power amplifier 102 and two peaking power amplifier 104 and 106. The ratio of the sizes of main 102 and peaking devices 104 and 106 can be adjusted to so as to shift the second efficiency peaking point of the PA to a position to match the power probability density function of the input modulated signals.

It is also noted that, in this schematic illustration of Figure 9, the wideband input match networks 108 and output matching network 110 are not included in the package and are provided with the components outside the package. Moreover, the DPA circuit of Figure 9 is also used with an external wideband input signal splitter/divider 112 which divided the input signal into a separate signal for each input of the DPA circuit. Also, a phase compensation network 114 (for example, a 90° transmission line) is employed at the input of the main power amplifier 102. This is to compensate for the additional phase shift caused by the 180° transmission lines connected to the peaking power amplifiers 104 and 106.

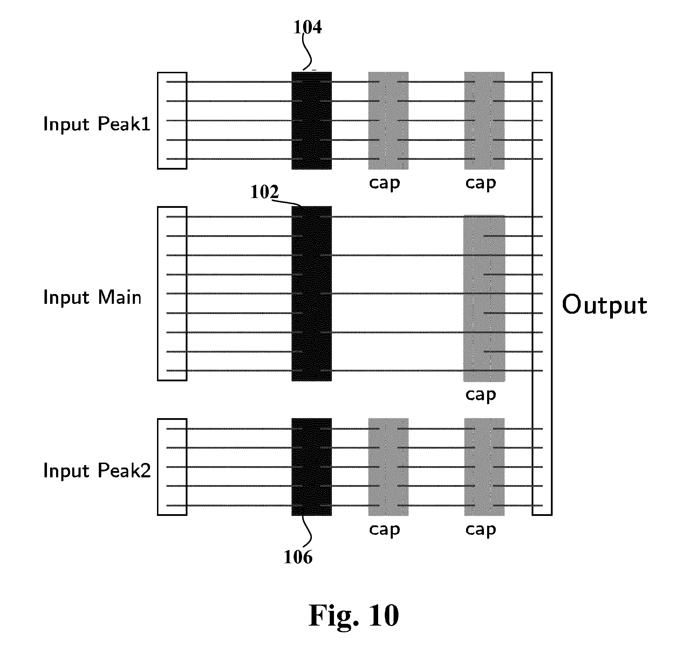

An exemplary assembly diagram of the integrated DPA circuit of Figure 9 is shown in Figure 10. This illustrates that the resulting circuit and assembly is compact, simple and does not require any special dice. Conventional power bars can be used to implement this circuit.

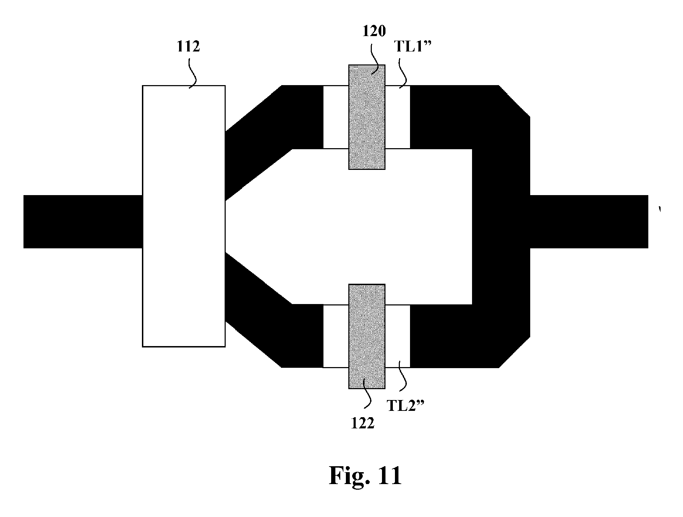

Embodiments can be made compact by making the part of the power combiner network in the main and the peaking devices using bond-wires and lumped capacitors. For example, referring to Figure 11 (which shows a simplified schematic diagram of an integrated DPA circuit according to an embodiment), the major part (i.e. the majority) of the 90° transmission line TL1" can be made inside the package of the main power amplifier 120 and, in the same way, the major part (i.e. the majority) of the 180° transmission line TL2" can be formed in the package of the peaking power amplifier 122. This would provide a more compact layout.

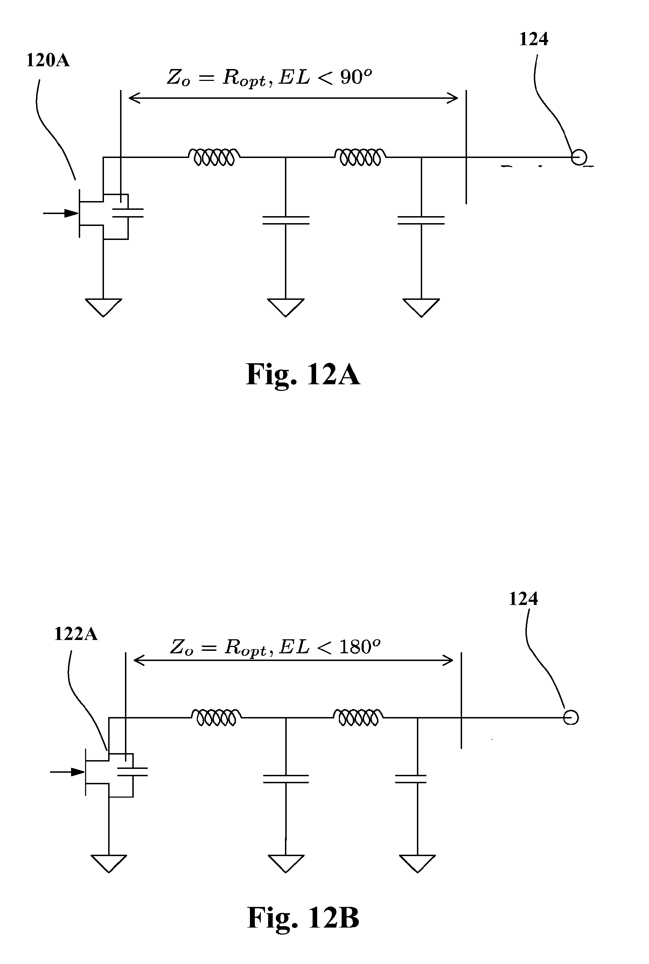

Figure 12A is a schematic circuit diagram of the packaged main power amplifier 102 of the embodiment shown in Figure 11. Here, the transmission line connected between the main power amplifier transistor 120A and the package terminal(s) 124 is arranged to have an electrical length of less than π/2 (i.e. less than a quarter wavelength).

Similarly, Figure 12B is a schematic circuit diagram of the packaged peaking power amplifier 122 of the embodiment shown in Figure 11. Here, the transmission line connected between the peaking power amplifier transistor 122A and the package terminal(s) 124 is arranged to have an electrical length of less than π (i.e. less than a half wavelength).

In other words, for each transmission line, part of the transmission line is provided inside the packaging of the associated packaged amplifier device, and the remaining part of the transmission line is provided outside (i.e. externally of) the packaging of the packaged amplifier device.

It will be appreciated that embodiments of the invention provide a bandwidth that may be 2.5 times the bandwidth of a conventional DPA circuit. Embodiments of the invention may also have the ability to absorb the device and package parasitic capacitance of the main and peaking devices. This may make it possible to take full advantage of the bandwidth when used/designed with discrete power amplifier devices. In such cases, the improvement in bandwidth may be further improved to 4 to 5 times that of a conventional DPA combiner.

Various modifications will be apparent to those skilled in the art.

## Claims

1. A Doherty power amplifier circuit comprising a main amplifier and peak amplifier connected to an output terminal of the circuit via a transmission line impedance invertor, wherein the transmission line impedance invertor comprises:
a first transmission line connected between the main amplifier and the output terminal; and
a second transmission line connected between the peak amplifier and the output terminal.

2. The circuit of claim 1, wherein the first and second transmission lines have different electrical lengths.

3. The circuit of claim 2, wherein the first transmission line has an electrical length of π/2 at a predetermined frequency of interest, and wherein the second transmission line has an electrical length of π at the predetermined frequency of interest.

4. The circuit of any claim 2 or 3, further comprising a phase compensating transmission line connected to the input of the main amplifier and having an electrical length adapted to compensate for the differing amount of phase shift caused by the differing electrical lengths of the first and second transmission lines.

5. The circuit of any preceding claim, wherein the first transmission line is formed from a transmission line impedance and at least one of: the main amplifier output capacitance; a package capacitance; a parasitic capacitance of the main amplifier; and a bond wire inductance.

6. The circuit of any preceding claim, wherein the second transmission line is formed from a transmission line impedance and at least one of: a package capacitance; and a parasitic capacitance of the peak amplifier.

7. The circuit of any preceding claim further comprising a further peak amplifier connected to the output terminal via the transmission line impedance invertor, wherein the transmission line impedance invertor further comprises a third transmission line connected between the further peak amplifier and the output terminal.

8. A radio frequency transmitter comprising a Doherty power amplifier circuit according to any preceding claim.

9. An integrated circuit comprising a Doherty power amplifier circuit according to any of claims 1 to 7.

10. A packaged integrated circuit comprising a Doherty power amplifier circuit according to any of claims 1 to 7, wherein at least part of at least one of the first and second transmission lines is provided inside the packaging of the packaged integrated circuit.
